# EUROPEAN PATENT SPECIFICATION

(11) **EP 4 561 035 B1**
(45) Date of publication and mention of the grant of the patent: **26.08.2026**
(21) Application number: 23893232.1
(22) Date of filing: 26.07.2023
(51) Int. Cl.: G06F 1/16, H04M 1/02, H04M 1/18

(54) **FOLDING ASSEMBLY AND FOLDABLE ELECTRONIC DEVICE**
KLAPPANORDNUNG UND KLAPPBARE ELEKTRONISCHE VORRICHTUNG
ENSEMBLE DE PLIAGE ET DISPOSITIF ÉLECTRONIQUE PLIABLE

(30) Priority: 22.11.2022 CN 202223114157 U
(43) Date of publication of application: 28.05.2025
(73) Proprietor: Honor Device Co., Ltd., Shenzhen, Guangdong 518040 (CN)
(72) Inventor: YU, Dengpan, Shenzhen, Guangdong 518040 (CN); ZHANG, Yaolei, Shenzhen, Guangdong 518040 (CN); LI, Qiancheng, Shenzhen, Guangdong 518040 (CN); GUO, Renwei, Shenzhen, Guangdong 518040 (CN)
(74) Representative: Goddar, Heinz J.
(86) International application number: PCT/CN2023/109226
(87) International publication number: WO 2024/109133

(56) References cited:
- CN-A- 110 445 913
- CN-A- 114 640 732
- US-A1- 2016 209 874
- US-A1- 2022 173 353

## Description

This application claims priority to Chinese Patent Application No. 202223114157.6, filed with the China National Intellectual Property Administration on November 22, 2022 and entitled "FOLDABLE ASSEMBLY AND FOLDABLE ELECTRONIC DEVICE'**.**

### TECHNICAL FIELD

Embodiments of this application relate to the field of electronic device technologies, and in particular, to a foldable assembly and a foldable electronic device.

### BACKGROUND

An electronic device is one of the most important tools in people's daily work and life. To resolve a problem that a conventional electronic device is in a relatively large size and is inconvenient to carry, a foldable electronic device appears. During use of the foldable electronic device, there is a problem that the foldable electronic device falls off due to improper use or slip of the hand.

Because there is a clearance between components of a foldable assembly of the foldable electronic device, impact resistance of a display screen is reduced. When the foldable electronic device falls off, components of the foldable electronic device are usually damaged to different degrees. In particular, a bending part of the display screen usually collides with a substrate of a rotating shaft, and consequently, a probability that the bending part is damaged is high.

CN 114 640 732 A describes an electronic device and a rotating shaft assembly, which can improve the influence of the first support plate and the second support plate on the bending area.

### SUMMARY

A foldable assembly and a foldable electronic device are provided in embodiments of this application, so that collision stress between a display screen and the foldable assembly during shaft-side corner falling of the foldable electronic device can be reduced without affecting overall strength of the foldable assembly. Therefore, damage to the display screen is avoided, and reliability of the foldable electronic device is improved.

According to a first aspect, this application provides a foldable assembly. The foldable assembly is applied to a foldable electronic device and includes a first body, a second body, and a rotating shaft. The rotating shaft includes a substrate, and the substrate is disposed between the first body and the second body. The substrate includes a first surface facing a bending part of a display screen of the foldable electronic device, and the first surface includes a support part and a recessed part. In a first direction, an end part on at least one side of the bending part forms a projection region on the first surface, the recessed part is disposed in correspondence with the projection region, and the recessed part includes the projection region. The end part on the at least one side is formed after an end surface of the bending part extends by a first distance in the first direction. In a second direction, there is a first gap between the bending part and the recessed part, there is a second gap between the bending part and the support part, and the first gap is greater than the second gap. The first direction is an axial direction of the substrate, the second direction is a thickness direction of the substrate, and the support part is a region on the first surface except the recessed part.

In the foldable assembly shown in this application, the recessed part may be disposed on the first surface in correspondence with the projection region, on the first surface, of the end part on the at least one side of the bending part, so that in the thickness direction of the substrate, the first gap between the bending part and the recessed part is greater than the second gap between the bending part and the support part. In this way, the display screen can be avoided by using the first gap during shaft-side corner falling of the foldable electronic device, so that collision stress between the display screen and the foldable assembly during shaft-side corner falling of the foldable electronic device can be reduced without affecting overall strength of the foldable assembly. Therefore, damage to the display screen is avoided, and reliability of the foldable electronic device is improved.

In an implementation, the recessed part includes a first end facing an end surface of the substrate, and there is a second distance between the end surface of the substrate and the first end. In this implementation, the first end of the recessed part may not be directly disposed from the end surface of the substrate, and another component such as a cover body may be further disposed on the end surface of the substrate, to protect the substrate or the display screen.

In an implementation, when the foldable electronic device is in a folded state, the first gap is a first value, the second gap is a second value, and the first value is greater than the second value; and when the foldable electronic device is in an unfolded state, the first gap is a third value, the second gap is a fourth value, and the third value is greater than the fourth value. The first value is different from the third value, and the second value is different from the fourth value. In this implementation, the first gap has different values and the second gap also has different values when the foldable electronic device is in the unfolded state and in the folded state. However, the first gap is always greater than the second gap regardless of whether the foldable electronic device is in the folded state or the unfolded state.

In an implementation, the recessed part includes at least one of a recess or an inclined surface. In this implementation, the recessed part may be in a plurality of structures. Different structures of the recessed part only need to avoid the display screen during shaft-side corner falling of the foldable electronic device.

In an implementation, the inclined surface includes at least one of an inclined curved surface or an inclined plane. In this implementation, the recessed part may be in a plurality of structures. Different structures of the recessed part only need to avoid the display screen during shaft-side corner falling of the foldable electronic device.

In an implementation, the recessed part includes a second end facing away from the end surface of the substrate, there is a third distance between the second end and the end surface of the substrate, and the third distance is greater than the second distance. In this implementation, the recessed part may have a specific length in the first direction. In this way, in a region corresponding to the length, there is a gap between the first surface and the bending part, so that collision stress between the display screen and the foldable assembly during shaft-side corner falling of the foldable electronic device can be reduced without affecting overall strength of the foldable assembly. Therefore, damage to the display screen is avoided, and reliability of the foldable electronic device is improved.

In an implementation, the substrate includes: a shaft cover, where the shaft cover is disposed opposite to the bending part; a cover plate, where the cover plate is located between the shaft cover and the bending part and is fixedly connected to the shaft cover to form a cavity; and a base, where at least a portion of the base is located inside the cavity. In this implementation, this design manner may be used for the substrate, to design a structure in this embodiment of this application.

In an implementation, the second gap is greater than or equal to 0.25 millimeter when the foldable electronic device is in a folded state. In this implementation, the structure shown in this embodiment of this application may be applied to a foldable electronic device with a second gap in this value range.

In an implementation, a difference between the first gap and the second gap is in a range of [0.1, 0.3] millimeter when the foldable electronic device is in the folded state. In this implementation, the first gap may be set in this value range, so that collision stress between the display screen and the foldable assembly during shaft-side corner falling of the foldable electronic device is reduced without affecting overall strength of the foldable assembly. Therefore, damage to the display screen is avoided, and reliability of the foldable electronic device is improved.

In an implementation, the second gap is less than or equal to 0.4 millimeter when the foldable electronic device is in the folded state. In this implementation, the structure shown in this embodiment of this application may be applied to a foldable electronic device with a second gap in this value range.

In an implementation, the rotating shaft further includes a swing arm assembly. A groove is disposed in the support part, and a first rotating member is disposed in the groove. The first rotating member includes a second surface, the second surface is a side surface of the first rotating member facing away from a bottom surface of the groove, the second surface is parallel to an opening of the groove, and the first rotating member is connected to the swing arm assembly. When the foldable electronic device is in an unfolded state, the first rotating member supports the bending part. In this implementation, when the foldable electronic device is in the unfolded state, to avoid reduction in strength of support by the substrate for the display screen that is caused by the first gap, the first rotating member may be used to assist in support for the display screen.

According to a second aspect, this application further provides a foldable electronic device. The foldable electronic device includes the foldable assembly according to the first aspect and the implementations of the first aspect.

In the foldable electronic device shown in this application, the recessed part may be disposed on the first surface in correspondence with the projection region, on the first surface, of the end part on the at least one side of the bending part, so that in the thickness direction of the substrate, the first gap between the bending part and the recessed part is greater than a second region between the bending part and the support part. In this way, the display screen can be avoided by using the first gap during shaft-side corner falling of the foldable electronic device, so that collision stress between the display screen and the foldable assembly during shaft-side corner falling of the foldable electronic device can be reduced without affecting overall strength of the foldable assembly. Therefore, damage to the display screen is avoided, and reliability of the foldable electronic device is improved.

### BRIEF DESCRIPTION OF DRAWINGS

To describe technical solutions in embodiments of this application more clearly, the following briefly describes accompanying drawings required in the embodiments. Clearly, a person of ordinary skill in the art may still derive other accompanying drawings from these accompanying drawings without creative efforts.
FIG. 1 is a schematic diagram of a foldable electronic device according to an embodiment of this application;
FIG. 2 is a schematic diagram of a foldable electronic device according to an embodiment of this application;
FIG. 3 is a schematic diagram of a rotating shaft assembly of a foldable electronic device according to an embodiment of this application;
FIG. 4 is a schematic diagram of a fallen state of a foldable electronic device according to an embodiment of this application;
FIG. 5A is a schematic diagram of a change in a cross-section of a foldable electronic device in a fallen state according to an embodiment of this application;
FIG. 5B is a diagram of a change in a partial cross-section of a foldable electronic device in a fallen state according to an embodiment of this application;
FIG. 5C is a diagram of a change in a partial cross-section of a foldable electronic device in a fallen state according to an embodiment of this application;
FIG. 5D is a diagram of a change in a partial cross-section of a foldable electronic device in a fallen state according to an embodiment of this application;
FIG. 6 is a schematic exploded view of a first type of structure of a foldable assembly according to an embodiment of this application;
FIG. 7 is a schematic diagram of a first type of structure of a foldable assembly according to an embodiment of this application;
FIG. 8 is a partially enlarged schematic diagram of a foldable assembly according to an embodiment of this application;
FIG. 9 is a schematic diagram of a combination of a swing arm assembly and a substrate according to an embodiment of this application;
FIG. 10 is a partial schematic diagram of a substrate according to an embodiment of this application;
FIG. 11 is a schematic top view of a first surface according to an embodiment of this application;
FIG. 12 is a schematic diagram of a third distance according to an embodiment of this application;
FIG. 13A is a top view of a recessed part according to an embodiment of this application;
FIG. 13B is a three-dimensional diagram of a recessed part according to an embodiment of this application;
FIG. 13C shows a spatial location relationship of a point O1 according to an embodiment of this application;
FIG. 13D shows a spatial location relationship of a point O2 according to an embodiment of this application;
FIG. 13E shows a spatial location relationship of a point O3 according to an embodiment of this application;
FIG. 13F shows a spatial location relationship of a point O4 according to an embodiment of this application;
FIG. 14A is a diagram of a change in a partial cross-section of a foldable electronic device in a fallen state according to an embodiment of this application;
FIG. 14B is a diagram of a change in a partial cross-section of a foldable electronic device in a fallen state according to an embodiment of this application;
FIG. 14C is a diagram of a change in a partial cross-section of a foldable electronic device in a fallen state according to an embodiment of this application;
FIG. 15 is a schematic diagram of a structure of a first rotating member according to an embodiment of this application;
FIG. 16 is a schematic diagram of a second type of structure of a foldable assembly according to an embodiment of this application;
FIG. 17 is a schematic diagram of a third type of structure of a foldable assembly according to an embodiment of this application; and
FIG. 18 is a schematic diagram of a fourth type of structure of a foldable assembly according to an embodiment of this application.

### DESCRIPTION OF EMBODIMENTS

The technical solutions in embodiments of this application are clearly described blow with reference to the accompanying drawings in embodiments of this application.

In the descriptions of this application, unless otherwise specified, "/" means "or". For example, A/B may represent A or B. In this specification, "and/or" is merely an association relationship for describing associated objects, and represents that three relationships may exist. For example, "A and/or B" may represent the following three cases: Only A exists, both A and B exist, and only B exists. In addition, "at least one" means one or more, and "a plurality of" means two or more. The words such as "first" and "second" do not limit a quantity or an execution sequence, and the words such as "first" and "second" do not indicate a definite difference.

It should be noted that in this application, the word such as "example" or "for example" is used to represent giving an example, an illustration, or a description. Any embodiment or design solution described as an "example" or "for example" in this application should not be explained as being more preferred or having more advantages than other embodiments or design solutions. Exactly, use of the word such as "example" or "for example" is intended to present a related concept in a specific manner.

The terms used in implementations of this application are merely intended to explain specific embodiments of this application and are not intended to limit this application. Embodiments of this application are described below in detail with reference to the accompanying drawings.

An application scenario of embodiments of this application is first described below with reference to the accompanying drawings.

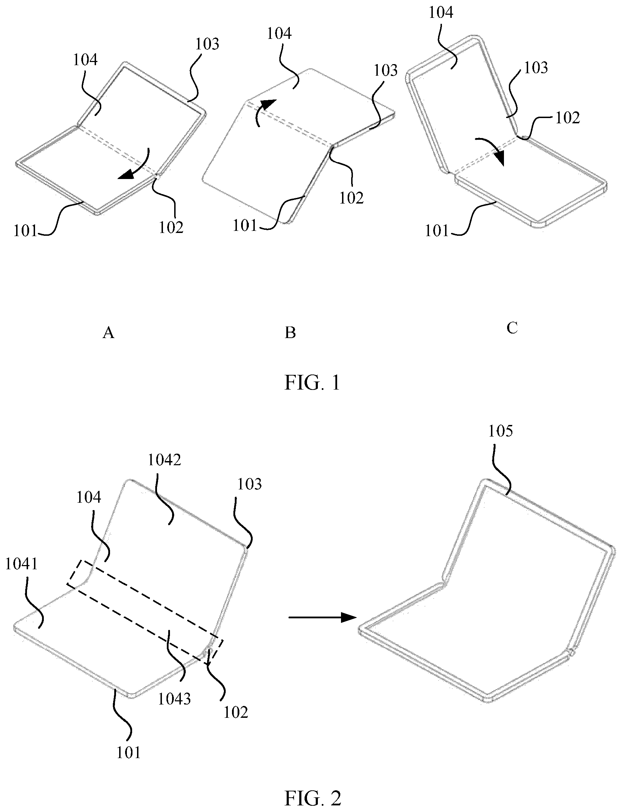

FIG. 1 is a schematic diagram of a foldable electronic device. The foldable electronic device is an electronic device whose display screen can be bent from 0 degrees to 360 degrees. The foldable electronic device usually includes a first body 101, a second body 103 rotatably connected to the first body 101 by using a rotating shaft assembly 102, and a display screen 104 disposed on one side of the first body 101 and the second body 103. Based on the foregoing structure, as shown in A in FIG. 1, the foldable electronic device may be disposed as an inward foldable electronic device; as shown in B in FIG. 1, the foldable electronic device may be disposed as an outward foldable electronic device; and as shown in C in FIG. 1, the foldable electronic device may be disposed as a vertically foldable electronic device.

It should be noted herein that a dashed line in FIG. 1 indicates a location of the rotating shaft assembly 102 of the foldable electronic device, and the location is invisible because the location is shielded by the display screen 104.

This embodiment of this application is applicable to a foldable electronic device for which side surfaces of a display screen 104 that are used to display images approach each other in a folded state, such as the inward foldable electronic device and the vertically foldable electronic device. The inward foldable electronic device is used as an example in all the following embodiments.

FIG. 2 is a schematic diagram of components of the foldable electronic device. As shown in FIG. 2, the display screen 104 of the foldable electronic device includes a first fastening part 1041, a second fastening part 1042, and a bending part 1043. The first fastening part 1041 is configured to be fixedly connected to the first body 101, the second fastening part 1042 is configured to be fixedly connected to the second body 103, and the bending part 1043 is configured to be displaced relative to the first fastening part 1041, the second fastening part 1042, and the rotating shaft assembly 102, to correspond to changes between a folded state and an unfolded state of the display screen 104.

The display screen 104 includes a display module and a transparent cover plate. The display module can display an image, a video, and the like. The display module may be a liquid crystal display (liquid crystal display, LCD), an organic light-emitting diode (organic light-emitting diode, OLED), an active-matrix organic light emitting diode or an active-matrix organic light emitting diode (active-matrix organic light emitting diode, AMOLED), a flex light-emitting diode (flex light-emitting diode, FLED), a Miniled, a MicroLed, a Micro-oLed, a quantum dot light-emitting diode (quantum dot light emitting diodes, QLED), or the like. The transparent cover plate covers an outer side of the display module to protect the display module. The transparent cover plate may be a glass cover plate, or may be another transparent material that can play a protection function. The display screen 104 may further have a touch function, that is, the display screen 104 may be a touchscreen. A side surface that is of the display screen 104 and that is configured to display an image is a side surface of the transparent cover plate facing away from the display module.

Further as shown in FIG. 2, the foldable electronic device further includes a bezel 105. After the bezel 105, the first body 101, and the second body 103 are fixedly connected, the first fastening part 1041 may be disposed on the first body 101, and the second fastening part 1042 may be disposed on the second body 103, so that the bezel 105, the first body 101, and the second body 103 play a function of limiting and supporting the display screen 104.

It should be noted herein that the bezel 105 may be integrally formed with the first body 101 and the second body 103, so that the first body 101, the second body 103, and the bezel 105 are jointly used as a middle frame of the foldable electronic device. The bezel 105 may be alternatively used as a portion of the middle frame and may be fixedly connected to the first body 101 and the second body 103 that are used as a housing of the foldable electronic device. A connection sequence and a connection relationship between the foregoing components are not limited in this application.

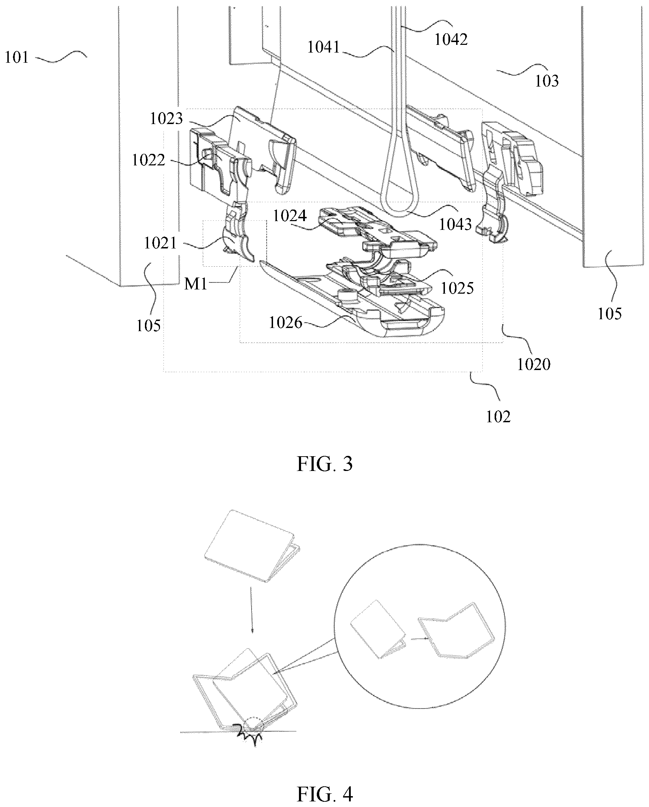

FIG. 3 is a schematic diagram of the rotating shaft assembly of the foldable electronic device. As shown in FIG. 3, the rotating shaft assembly 102 may include a swing arm 1021, a wedge-shaped block 1022, a door panel 1023, a cover plate 1024, a base 1025, and a shaft cover 1026. The shaft cover 1026 is disposed opposite to the bending part 1043, and the cover plate 1024 is located between the shaft cover 1026 and the bending part 1043, and is fixedly connected to the shaft cover 1026 to form a cavity. At least a portion of the base 1025 is located inside the cavity. A combination including the cover plate 1024, the base 1025, and the shaft cover 1026 is used as a substrate 1020 of the rotating shaft assembly 102, to facilitate disposing of other components. The swing arm 1021 is integrally formed with the wedge-shaped block 1022, and a virtual sliding tab (as shown by a region M1 in FIG. 3) of the swing arm 1021 is connected to an annular groove including the base 1025 and the cover plate 1024. In addition, the virtual sliding tab is further connected to a virtual shaft of the door panel 1023. In this connection manner, the wedge-shaped block 1022 is fixedly connected to the bezel 105. Because the display screen 104 is also fixedly connected to the bezel 105, displacement of the wedge-shaped block 1022, the swing arm 1021, and the door panel 1023 relative to the substrate 1020 may cause the bezel 105 and the display screen 104 to change from the folded state to the unfolded state.

It should be noted herein that FIG. 3 is merely a partial schematic diagram of the rotating shaft assembly 102, that is, a region in which an end part on one side of the rotating shaft assembly 102 extends by a specific distance from an end surface of the rotating shaft assembly 102 in an axial direction of the rotating shaft assembly. The actual rotating shaft assembly 102 further includes another portion that is axially symmetrically disposed with the schematic diagram, and the another portion is not shown in FIG. 3. All actual descriptions in this application are provided by using overall disposing of the rotating shaft assembly 102.

FIG. 4 is a schematic diagram of a fallen state of the foldable electronic device. As shown in FIG. 4, for example, the foldable electronic device is in the folded state. Due to an effect of inertia, a shaft-side corner of the foldable electronic device falls to the ground first, that is, shaft-side corner falling occurs on the foldable electronic device. In a shaft-side corner falling process, a location at which the shaft-side corner is in contact with the ground remains unchanged, and the foldable electronic device is unfolded due to stress. In this case, the bezel 105 and the display screen 104 are displaced toward the rotating shaft assembly 102, causing collision between the bending part 1043 and the cover plate 1024. Therefore, the display screen 104 is damaged.

FIG. 5A is a schematic diagram of a change in a cross-section of the foldable electronic device in the fallen state.

A in FIG. 5A is a schematic diagram of the entire foldable electronic device before falling. H1 is a sectioning plane of the foldable electronic device, and Q1 is a projection direction of the sectioning plane H1. B in FIG. 5A is a top view of the foldable electronic device. A sectioning line K1 is a projection of the sectioning plane H1 in the top view. C in FIG. 5A is a partial schematic diagram of a cross-sectional view of the foldable electronic device in a Q1 direction. The cross-sectional view shown in C in FIG. 5A is obtained by performing sectioning based on A and B in FIG. 5A. D in FIG. 5A is a partial schematic diagram obtained after the foldable electronic device is sectioned along a sectioning line K2 shown in C in FIG. 5A. E in FIG. 5A is a simplified schematic diagram of a spatial relationship between the substrate and the bending part that are of the foldable electronic device before falling. A sectioning line K3 is a projection of the sectioning plane H1 in a direction of a side view.

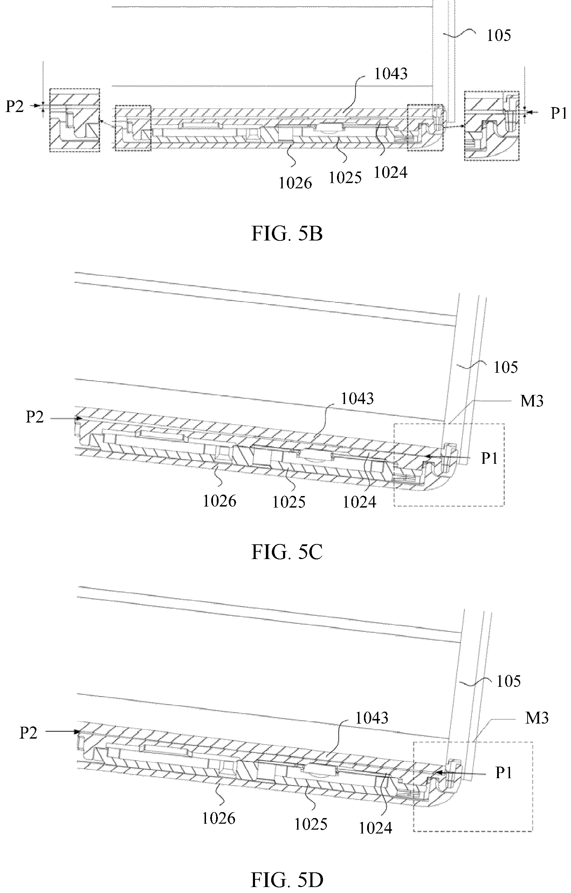

FIG. 5B is a partially enlarged schematic diagram corresponding to a region M2 in C in FIG. 5A. In other words, only a schematic cross-sectional view of a region in which an end part on one side of the rotating shaft assembly 102 extends by a specific distance in an axial direction of the rotating shaft assembly 102 from an end surface of the rotating shaft assembly 102 is shown. As shown in FIG. 5B, for example, shaft-side corner falling occurs when the foldable device is in the folded state. Before the foldable electronic device falls off, the bending part 1043 has a projection region on a side surface of the cover plate 1024 facing the bending part 1043, and there is a gap between the projection region on the surface and the bending part 1043. Gaps between the projection region and the bending part 1043 are equal. In other words, P1 and P2 are equal, as shown in the figure.

Both FIG. 5C and FIG. 5D are partial cross-sectional views corresponding to the region shown in FIG. 5B. FIG. 5C is a diagram of a change in a partial cross-section of the foldable electronic device in the fallen state. As shown in FIG. 5C, when the foldable electronic device is in an initial state of shaft-side corner falling, the shaft-side corner (as shown by the region M3 in FIG. 5C) is in contact with the ground. In this case, a speed of this contact region decreases to 0, and another region continues to fall due to inertia. The bezel 105 and the display screen 104 are displaced toward the rotating shaft assembly 102. In this case, an end part on one side of the bending part 1043 is in contact with the cover plate 1024 first, that is, P1 shown in the figure is equal to 0; and there is a gap between a side surface of the cover plate 1024 and the region in which the end part on one side of the bending part 1043 extends by the specific distance in the axial direction of the rotating shaft assembly 102 from the end surface of the rotating shaft assembly 102, that is, P2 shown in the figure has a specific distance. For example, P2 is equal to 0.1 millimeter. In this case, the shaft-side corner in the region M3 is subject to relatively large stress.

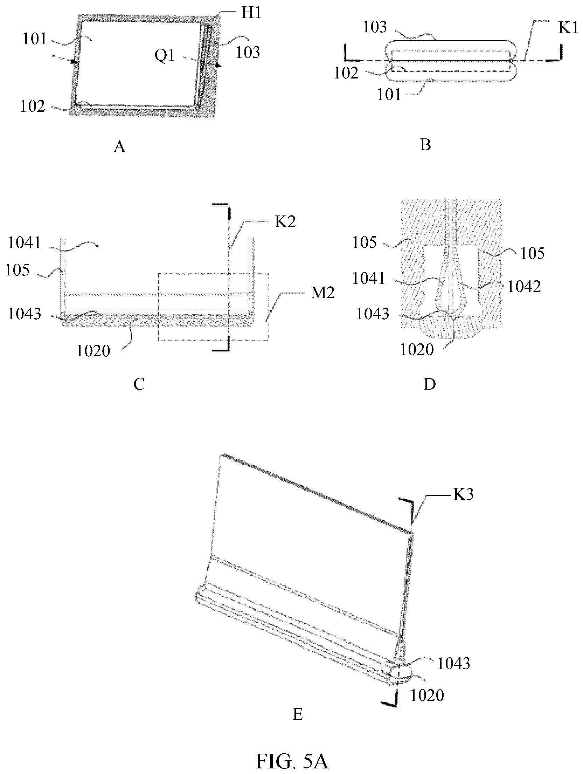

FIG. 5D is a diagram of a change in a partial cross-section of the foldable electronic device in the fallen state. As shown in FIG. 5D, when the foldable electronic device is in an end state of shaft-side corner falling, the bending part 1043 is in full contact with the side surface of the cover plate 1024 facing the bending part 1043, that is, P1 shown in the figure is equal to 0, and P2 is equal to 0. In this case, the region M3 continuously bears relatively large stress. As shown in FIG. 5Ato FIG. 5D, in a process in which the fallen state of the foldable electronic device changes, relatively large collision stress is borne from the initial state to the end state of shaft-side corner falling. Therefore, a conventional manner of disposing the rotating shaft assembly 102 in the foldable electronic device easily causes damage to the display screen 104 during shaft-side corner falling.

An embodiment of this application shows a foldable assembly, to resolve the following problem: When the foldable electronic device falls off, the bending part 1043 usually collides with the substrate used for disposing the rotating shaft assembly 102, and consequently, a probability that the bending part 1043 is damaged is high.

The foldable assembly shown in this application may be applied to a foldable electronic device. The foldable electronic device in this application includes but is not limited to a mobile phone, a display, a tablet computer, an in-vehicle computer, and the like. A specific form of the foldable electronic device is not specially limited in embodiments of this application.

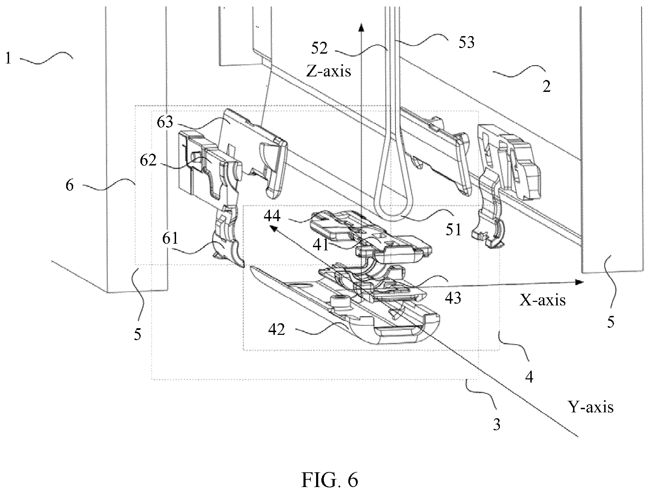

FIG. 6 is a schematic exploded view of a first type of structure of a foldable assembly according to an embodiment of this application. As shown in FIG. 6, the foldable assembly may include a first body 1, a second body 2, and a rotating shaft 3. The rotating shaft 3 may include a substrate 4. The substrate 4 may be disposed between the first body 1 and the second body 2, and the substrate 4 includes a first surface 41 facing a bending part 51 of a display screen 5 of a foldable electronic device.

In this embodiment of this application, an axial direction of the substrate 4 is a Y-axis direction, a thickness direction of the substrate 4 is a Z-axis direction, and a direction perpendicular to a plane in which the Y-axis and the Z-axis are located is an X-axis direction. Directions indicated by arrows shown in FIG. 6 are positive directions of the X-axis, the Y-axis, and the Z-axis. An X-axis direction, a Y-axis direction, and a Z-axis direction that are involved in the following embodiments of this application are subject to this.

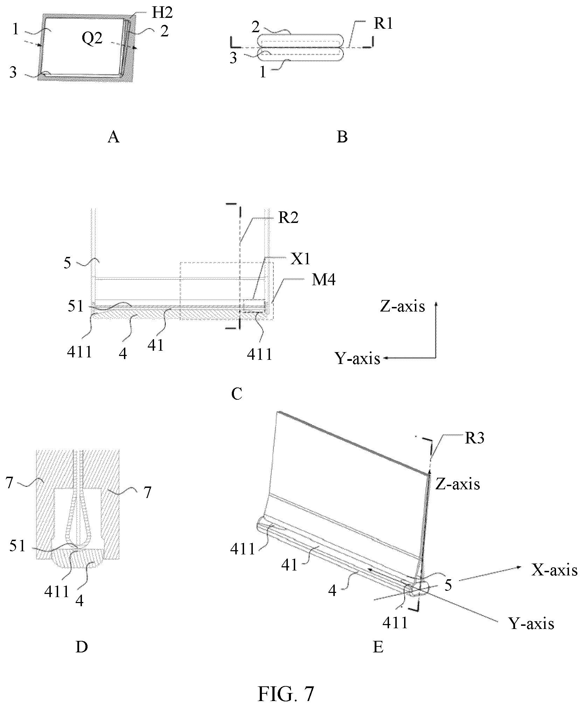

A in FIG. 7 is an overall schematic diagram of the first type of structure of the foldable assembly according to an embodiment of this application. H2 is a sectioning plane of the foldable electronic device, and Q2 is a projection direction for the sectioning plane H2. B in FIG. 7 is a top view of the foldable electronic device according to an embodiment of this application. A sectioning line R1 is a projection of the sectioning plane H2 in the top view. C in FIG. 7 is a partial schematic diagram of a cross-sectional view of the foldable electronic device in a Q2 direction according to an embodiment of this application. The cross-sectional view shown in C in FIG. 7 is obtained by performing sectioning based on A and B in FIG. 7. D in FIG. 7 is a partial schematic diagram obtained after the foldable electronic device is sectioned along a sectioning line R2 shown in C in FIG. 7. E in FIG. 7 is a simplified schematic diagram of a spatial relationship between the substrate and the bending part of the foldable electronic device. A sectioning line R3 is a projection of the sectioning plane H2 in a direction of a side view.

It should be noted herein that an end part of the foldable assembly is a region corresponding to X1, and includes an end part of the substrate 4 and an end part of the bending part 51. The end part of the bending part 51 is formed after an end surface on one side of the bending part 51 extends by a specific distance in the Y-axis direction, and the end part of the substrate 4 is formed after an end surface on one side of the substrate 4 extends by a specific distance in the Y-axis direction. In this embodiment of this application, the substrate 4 includes an end part on at least one side, and the bending part 51 includes an end part on at least one side.

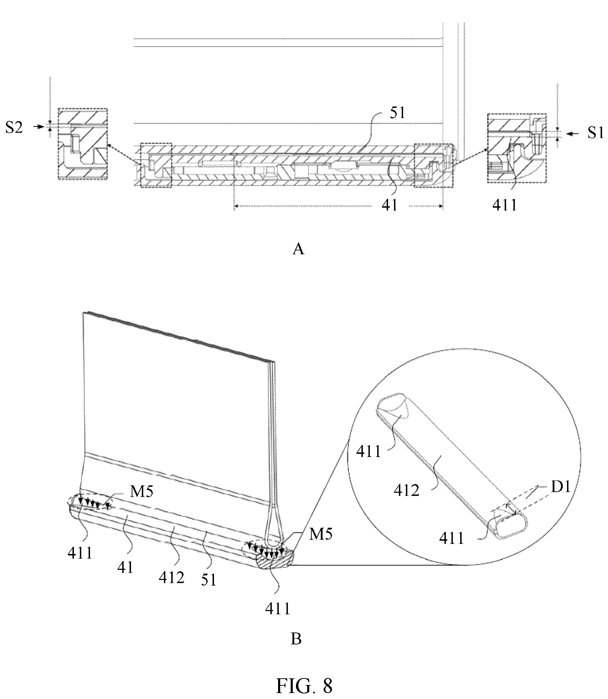

A in FIG. 8 is a partially enlarged schematic diagram corresponding to a region M4 in C in FIG. 7. B in FIG. 8 is a partial three-dimensional schematic diagram corresponding to the region M4 in C in FIG. 7.

As shown in A and B in FIG. 8, in some embodiments, an end part on at least one side of the bending part 51 is formed after an end surface of the bending part 51 extends by a first distance D1 in the Y-axis direction. For example, the first distance D1 may be 13 millimeters. It should be noted herein that a specific value of the first distance D1 is not set in this embodiment of this application, and the first distance D1 may be less than or equal to 80 millimeters.

The first surface 41 includes a recessed part 411 and a support part 412. The support part 412 is a region on the first surface 41 except the recessed part 411. In a first direction, an end part on at least one side of the bending part 51 forms a projection region M5 on the first surface 41, the recessed part 411 is disposed in correspondence with the projection region M5, and the recessed part 411 includes the projection region M5. The first direction is the axial direction of the substrate 4, that is, the Y-axis direction.

In a second direction, there is a first gap S1 between the bending part 51 and the recessed part 411, there is a second gap S2 between the bending part 51 and the support part 412, and the first gap S1 is greater than the second gap S2. The second direction is the thickness direction of the substrate, that is, the Z-axis direction. In this way, the recessed part 411 can avoid the display screen 5 when shaft-side corner falling occurs on the foldable electronic device.

Further as shown in FIG. 6, in some embodiments, the substrate 4 may include a shaft cover 42, a base 43, and a cover plate 44. The shaft cover 42 may be disposed opposite to the bending part 51. The cover plate 44 is located between the shaft cover 42 and the bending part 51, and is fixedly connected to the shaft cover 42 to form a cavity, and at least a portion of the base 43 is located inside the cavity.

In some embodiments, the rotating shaft 3 may further include a swing arm assembly 6, and the swing arm assembly 6 may include a swing arm 61, a wedge-shaped block 62, and a door panel 63.

Further as shown in FIG. 6, the display screen 5 is disposed on the first body 1 and the second body 2. Based on different connection relationships between the display screen 5 and both the first body 1 and the second body 2, the display screen 5 may include the bending part 51, a first fastening part 52, and a second fastening part 53. The first fastening part 52 is configured to be fixedly connected to the first body 1, the second fastening part 53 is configured to be fixedly connected to the second body 2, and the bending part 51 corresponds to locations of the swing arm assembly 6 and the substrate 4 and is in a free state, and can be displaced relative to the first fastening part 52 and the second fastening part 53, to adapt to a folding and unfolding function of the foldable assembly. When the foldable assembly is in a folded state, the bending part 51 may be in a bent state of a waterdrop shape. It should be noted herein that a specific material of the display screen 5 may be set with reference to the display screen 104 in the foregoing embodiment. Details are not described in this application.

A bezel 7 may be disposed on edges of the display screen 5, the first body 1, and the second body 2, and is fixedly connected to these components, to play a limiting and supporting function. It should be noted herein that the bezel 7 may be integrally formed with the first body 1 and the second body 2, so that the first body 1, the second body 2, and the bezel 7 are jointly used as a middle frame of the foldable electronic device. The bezel 7 may be alternatively used as a portion of the middle frame and may be fixedly connected to the first body 1 and the second body 2 that are used as a housing of the foldable electronic device.

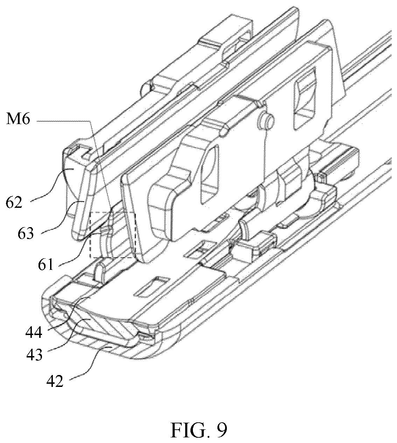

FIG. 9 is a schematic diagram of a combination of the swing arm assembly and the substrate according to an embodiment of this application. As shown in FIG. 9, the swing arm 61 may be integrally formed with the wedge-shaped block 62, and a virtual sliding tab (as shown by a region M6 in FIG. 9) of the swing arm 61 is connected to an annular groove including the base 43 and the cover plate 44, and in addition, the virtual sliding tab is further connected to a virtual shaft of the door panel 63. Because the wedge-shaped block 62 is fixedly connected to the bezel 7, and the display screen 5 is also fixedly connected to the bezel 7, displacement of the swing arm 11, the wedge-shaped block 12, and the door panel 13 relative to the substrate 4 in the Z-axis direction may enable the bezel 7 and the display screen 5 to change from the folded state to an unfolded state.

It should be noted herein that the rotating shaft 3 and the substrate 4 each include but are not limited to the components shown in this embodiment of this application, and the rotating shaft 3 and the substrate 4 each may be disposed with more or fewer components. This is not limited in this application.

The first surface 41 may be a side surface of the cover plate 44 facing the bending part 51. When the substrate 4 is another structure that does not include the cover plate 44, the first surface 41 may be alternatively a side surface of another component facing the bending part 51. In this embodiment of this application, a specific component to which the first surface 41 belongs is not limited, and the first surface 41 may be a surface of any component that collides with the bending part 51.

In some embodiments, the base 43 and the shaft cover 42 may be an integrally formed structure, or the base 43 may be a structure separated from the shaft cover 42. A manner of connecting components of the rotating shaft 3 and the substrate 4 is not limited in this embodiment of this application.

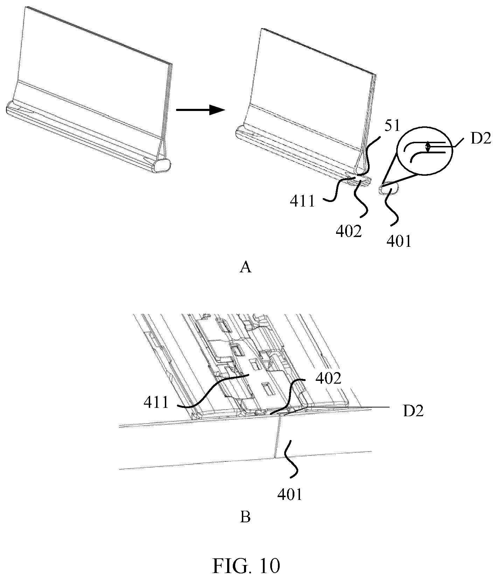

FIG. 10 is a partial schematic diagram of the substrate according to an embodiment of this application. A in FIG. 10 is a partial schematic diagram of the substrate in a folded state according to an embodiment of this application. B in FIG. 10 is a partial schematic diagram of the substrate in an unfolded state according to an embodiment of this application. As shown in A and B in FIG. 10, in some embodiments, the recessed part 411 includes a first end 402 facing an end surface 401 of the substrate, and there is a second distance D2 between the end surface 401 of the substrate 4 and the first end 402 in the Y-axis direction. An edge of the substrate 4 usually includes a portion of the shaft cover 42 to support the display screen 5 when the foldable electronic device is in the unfolded state. Therefore, the recessed part 411 does not need to be disposed from the end surface 401 of the substrate 4 to avoid the display screen 5, and only needs to be disposed in correspondence with a projection region of the end part of the bending part 51 on the first surface 41. In this case, the second distance D2 may be a thickness of the shaft cover 42. It should be noted herein that only the shaft cover 42 is used as an example for description in this application, and the second distance D2 between the end surface 401 of the substrate and the first end 402 of the recessed part 411 may be alternatively set to a structure with one or more other types of components. It should be noted that a region of the recessed part 411 may be greater than or equal to the projection region of the end part of the bending part 51 on the first surface 41, to provide specific displacement space when shaft-side corner falling occurs on the bending part 51, so that collision between the bending part 51 and the shaft cover 42 is avoided.

In specific implementation, the recessed part 411 may be disposed as at least one of a recess or an inclined surface. A specific shape of the recessed part 411 is not limited in this embodiment of this application. The recessed part 411 may be alternatively in a stepped shape or another shape. Based on such a manner of disposing the recess, the inclined surface, and the stepped shape, a height of the recessed part 411 in the Z-axis direction is lower than a height of the support part 412 in the Z-axis direction, and the recessed part 411 may avoid the display screen 5 when shaft-side corner falling occurs on the foldable electronic device. Therefore, any recessed part 411 designed in such a disposing manner and a derivative form of such a disposing manner may be applied to this embodiment of this application.

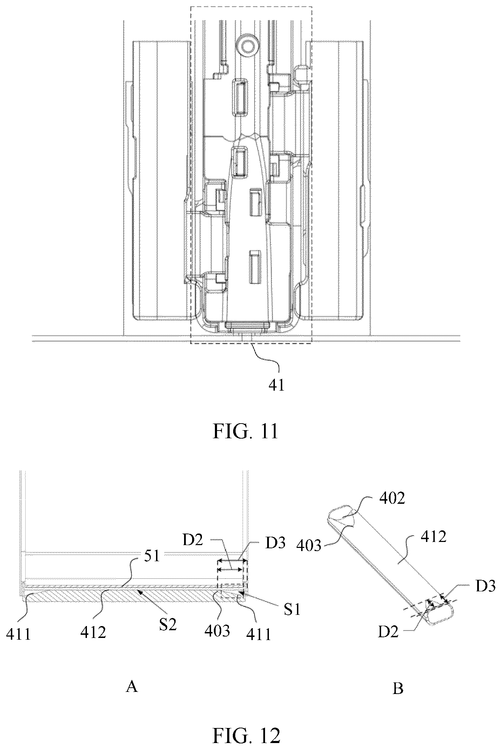

FIG. 11 is a schematic top view of the first surface according to an embodiment of this application. As shown in FIG. 11, the first surface 41 may be a smooth surface, or another component may be disposed on the first surface 41. In some embodiments, the inclined surface may include at least one of a continuous surface or a discontinuous surface. In this embodiment of this application, continuity of a plane in which the recessed part 411 is located is not limited. In some embodiments, the inclined surface may include at least one of an inclined curved surface or an inclined plane. In some embodiments, the inclined surface may include at least one of a curved surface whose curvature gradually increases or a curved surface whose curvature gradually decreases.

The first type of structure of the foldable assembly in this embodiment of this application is an example in which the recessed part 411 is an inclined surface and the inclined surface is a continuous curved surface.

FIG. 12 is a schematic diagram of a third distance according to an embodiment of this application. In some embodiments, the recessed part 411 includes a second end 403 facing away from the end surface of the substrate 4, there is a third distance D3 between the second end 403 and the end surface of the substrate 4, and the third distance D3 is greater than the second distance D2. A in FIG. 12 is a schematic cross-sectional view of the third distance according to an embodiment of this application. This cross-section is a same cross-section as that in C in FIG. 7. B in FIG. 12 is a schematic three-dimensional diagram of the third distance according to an embodiment of this application. As shown in A and B in FIG. 12, a corresponding gap between the recessed part 411 and the bending part 51 gradually decreases from the first end 402 to the second end 403, and a gap between the support part 412 and the corresponding bending part 51 remains unchanged.

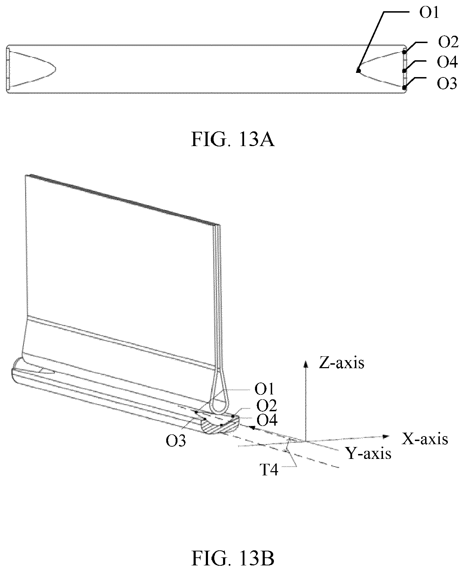

FIG. 13A to FIG. 13F are schematic diagrams of the recessed part according to an embodiment of this application.

FIG. 13A is a top view of the recessed part according to an embodiment of this application.

FIG. 13B is a three-dimensional diagram of the recessed part according to an embodiment of this application. As shown in FIG. 13A and FIG. 13B, the recessed part 411 includes a point O1, a point O2, a point O3, and a point O4. The point O1, the point O2, and the point O3 are vertices in the top view of the recessed part 411. The point O2, the point O3, and the point O4 are vertices in a side view of the recessed part 411.

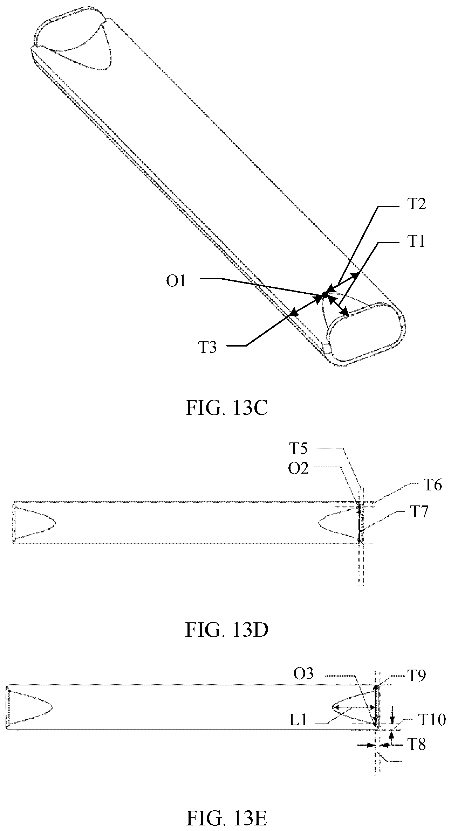

FIG. 13C shows a spatial location relationship of the point O1 according to an embodiment of this application. As shown in FIG. 13B and FIG. 13C, the point O1 is in a plane in which the support part of the first surface 41 is located. There is a first spacing T1 between the point O1 and the end surface of the substrate 4 in a negative direction of the Y-axis. For example, the first spacing T1 may be 13 millimeters. The substrate 4 has two side surfaces in the X-axis direction. There is a second spacing T2 between the point O1 and a side surface of the substrate 4 in a positive direction of the X-axis. For example, the second spacing T2 may be 3.7 millimeters. There is a third spacing T3 between the point O1 and a side surface of the substrate 4 in a negative direction of the X-axis. For example, the third spacing T3 may be 3.7 millimeters. There is a fourth spacing T4 between the point O1 and a bottom surface of the substrate 4 in a negative direction of the Z-axis. For example, the fourth spacing T4 may be 6 millimeters.

FIG. 13D shows a spatial location relationship of the point O2 according to an embodiment of this application. As shown in FIG. 13D, the point O2 is in the plane in which the support part of the first surface 41 is located. There is a fifth spacing T5 between the point O2 and the end surface of the substrate 4 in the negative direction of the Y-axis. For example, the fifth spacing T5 is 1 millimeter. There is a sixth spacing T6 between the point O2 and the side surface of the substrate 4 in the positive direction of the X-axis. For example, the sixth spacing T6 is 1.2 millimeters. There is a seventh spacing T7 between the point O2 and the side surface of the substrate 4 in the negative direction of the X-axis. For example, the seventh spacing T7 is 6.2 millimeters. Because the point O2 and the point O1 are in the same plane, a distance between the point O2 and the bottom surface of the substrate 4 in the negative direction of the Z-axis is the same as the fourth spacing T4, and is not shown in the accompanying drawing.

FIG. 13E shows a spatial location relationship of the point O3 according to an embodiment of this application. As shown in FIG. 13E, the point O3 is in the plane in which the support part of the first surface 41 is located. There is an eighth spacing T8 between the point O3 and the end surface of the substrate 4 in the negative direction of the Y-axis. For example, the eighth spacing T8 is 1 millimeter. There is a ninth spacing T9 between the point O3 and the side surface of the substrate 4 in the positive direction of the X-axis. For example, the ninth spacing T9 is 6.2 millimeters. There is a tenth spacing T10 between the point O3 and the side surface of the substrate 4 in the negative direction of the X-axis. For example, the tenth spacing T10 is 1.2 millimeters. Because the point O3 and the point O1 are in the same plane, a distance between the point O3 and the bottom surface of the substrate 4 in the negative direction of the Z-axis is the same as the fourth spacing T4, and is not shown in the accompanying drawing.

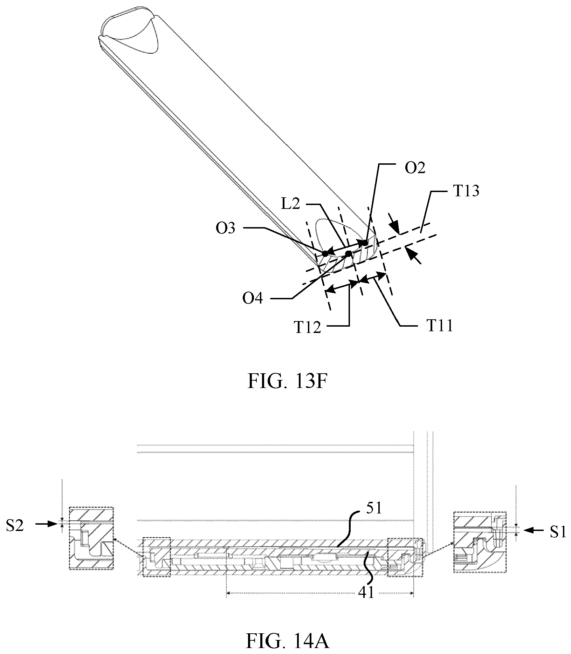

FIG. 13F shows a spatial location relationship of the point O4 according to an embodiment of this application. As shown in FIG. 13F, the point O4 is in the same plane as the point O2 and the point O3. Therefore, a distance between the point O4 and the end surface of the substrate 4 in the negative direction of the Y-axis is the same as the eighth spacing T8, and is not shown in the accompanying drawing. There is an eleventh spacing T11 between the point O4 and the side surface of the substrate 4 in the positive direction of the X-axis. For example, the eleventh spacing T11 is 3.7 millimeters. There is a twelfth spacing T12 between the point O4 and the side surface of the substrate 4 in the negative direction of the X-axis. For example, the twelfth spacing T12 is 3.7 millimeters. There is a thirteenth spacing T13 between the point O4 and the bottom surface of the substrate 4 in the negative direction of the Z-axis. For example, the thirteenth spacing T13 may be 3 millimeters.

Further as shown in FIG. 13E and FIG. 13F, an axial length L1 of the recessed part 411 is a distance between the point O1 and a plane in which the first end 402 of the recessed part 411 is located in the Z-axis direction. For example, the axial length L1 of the recessed part 411 may be 12 millimeters. A radial length L2 of the recessed part 411 is a distance between projections of the point O2 and the point O3 in a radial direction. For example, the radial length L2 of the recessed part 411 may be 5 millimeters. Based on the structure in the foregoing embodiment, the first gap S1 and the second gap S2 are in a corresponding size relationship. In some embodiments, when the second gap S2 is 0.25 millimeter, the first gap S1 may be greater than 0.25 millimeter. For example, the first gap S1 is 0.3 millimeter.

The first gap S1 may be designed by selecting a proper value based on a size of the second gap S2. If a value of the second gap S2 is relatively small, the value of the first gap S1 may be designed to be relatively large, to generate more avoidance for the display screen 5. If the value of the second gap S2 is relatively large, because there is already some avoidance space between the bending part 51 and the substrate 4, the value of the first gap S1 may be designed to be relatively small. In this embodiment of this application, sizes of the first gap S1 and the second gap S2 are not limited. A gap range shown in this embodiment of this application is merely used for example description, and a specific gap size may be set based on an actual situation.

In some embodiments, when the foldable electronic device is in the folded state, the second gap S2 may be greater than or equal to 0.25 millimeter.

In some embodiments, when the foldable electronic device is in the folded state, the second gap S2 may be less than or equal to 0.4 millimeter.

In some embodiments, when the foldable electronic device is in the folded state, a difference between the first gap S1 and the second gap S2 is in a range of [0.1, 0.3] millimeter.

It should be noted herein that the values involved in the foregoing embodiments are merely used for example description. The foregoing values are merely used to describe a spatial relationship of the points of the recessed part 411. Because the thirteenth spacing T13 is less than the fourth spacing T4, the recessed part 411 is formed due to such a difference. In this way, because the recessed part 411 is disposed on the substrate 4, the recessed part 411 is made thinner than the support part 412, so that when the support part 412 can support the display screen 5, the recessed part 411 can further avoid the display screen 5 when shaft-side corner falling occurs.

The recessed part 411 generated based on the values in the foregoing embodiment can enable a sinking amount of the first surface 41 be to relatively small, so that no large impact is exerted on strength of the first surface 41. Therefore, the technical solution shown in this embodiment of this application exerts no impact on a supporting capability for the display screen 5 when the foldable electronic device is in the unfolded state.

FIG. 14A is a schematic diagram of a partial cross-section of the foldable electronic device in the fallen state. FIG. 12A is a partially enlarged schematic diagram corresponding to the region M4 in C in FIG. 7. As shown in FIG. 14A, for example, the foldable electronic device falls off when in the folded state. Before the foldable electronic device falls off, a corresponding gap between the recessed part 411 and the bending part 51 gradually decreases from the first end 402 to the second end 403, that is, the first gap S1 shown in FIG. 14A is greater than the second gap S2. For example, S1 is 0.15 millimeter, and S2 is 0.1 millimeter.

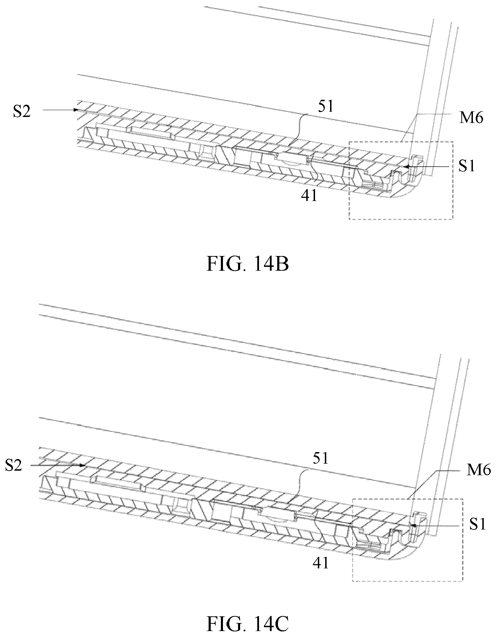

Both FIG. 14B and FIG. 14C are partial cross-sectional views corresponding to the region shown in FIG. 14A. FIG. 14B is a diagram of a change in a partial cross-section of the foldable electronic device in the fallen state. As shown in FIG. 14B, when the foldable electronic device is in an initial state of shaft-side corner falling, the shaft-side corner (as shown by a region M6 in FIG. 14B) is in contact with the ground. In this case, a speed of this region decreases to 0. Because the first surface 41 has the recessed part 411, the bending part 51 may continue to fall. In addition, another region continues to fall due to inertia, and the bezel 7 and the bending part 51 are displaced toward the first surface 41. In this process, an end part on one side of the bending part 51 is not in contact with the first end of the recessed part 411. In other words, as shown in the figure, the first gap S1 has a specific distance, and the second gap S2 has a specific distance. For example, S1 is 0.1 millimeter, and S2 is 0.1 millimeter. Avoidance generated by the first surface 41 to the bending part 51 in the initial state of shaft-side corner falling can reduce stress borne by the bending part 51 in this process.

FIG. 14C is a diagram of a change in a partial cross-section of the foldable electronic device in the fallen state according to an embodiment of this application. As shown in FIG. 14C, when the foldable electronic device is in an end state of shaft-side corner falling, the bending part 51 is in full contact with the first surface 41, that is, as shown in the figure, P1 is equal to 0, and P2 is equal to 0. In this case, because a relatively large amount of stress has been consumed in the initial state of shaft-side corner falling, in the end state of shaft-side corner falling, stress borne by the region M6 is relatively small, and stress borne by the bending part 51 is relatively small. This does not cause relatively large deformation of the display screen 5, and does not cause damage to the display screen 5.

In some embodiments, when the foldable electronic device is in the folded state, the first gap S1 is a first value, the second gap S2 is a second value, and the first value is greater than the second value; and when the foldable electronic device is in the unfolded state, the first gap S3 is a third value, the second gap S2 is a fourth value, and the third value is greater than the fourth value. The first value is different from the third value, and the second value is different from the fourth value. In this way, based on the first type of structure of the foldable assembly, the gap between the recessed part 411 and the bending part 51 changes when the foldable electronic device is in the folded state and the unfolded state, thereby generating different effects. When the foldable electronic device is in the folded state, the first gap S1 avoids the display screen 5 when shaft-side corner falling occurs on the foldable electronic device. If a relatively small first value is used for the first gap S1, impact on strength of support for the display screen 5 can be reduced while avoidance is performed. If a relatively large first value is used for the first gap S1, the strength of the support for the display screen 5 may be affected.

It should be noted herein that this embodiment of this application shows only a case in which the first value is different from the third value and the second value is different from the fourth value. In specific implementation, there is a case in which the first value is equal to the third value and the second value is equal to the fourth value. This is not limited in this embodiment of this application.

The strength of the support for the display screen 5 is not affected while a better avoidance effect is generated. The foldable assembly may further include a first rotating member 8, so that the first rotating member 8 may support the display screen 5 in place of the first surface 41 when the foldable electronic device is in the unfolded state, to prevent a case in which strength of support of the substrate 4 for the display screen 5 is changed because the recessed part 411 is disposed on the first surface 41.

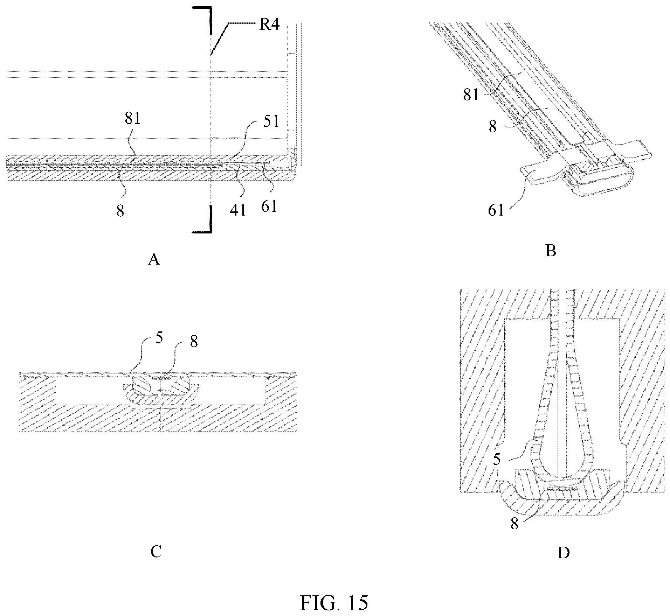

FIG. 15 is a schematic diagram of a structure of the first rotating member according to an embodiment of this application. A in FIG. 15 is a schematic diagram of a cross-sectional structure of the first rotating member according to an embodiment of this application. This schematic diagram is a same region as the region M4 shown in C in FIG. 7. As shown in A in FIG. 15, a groove is disposed in a region between recessed parts 411 on the first surface 41, a first rotating member 8 is disposed in the groove, the first rotating member 8 includes a second surface 81, the second surface 81 is a side surface of the first rotating member 8 facing away from a bottom surface of the groove, and the second surface 81 is parallel to an opening of the groove. B in FIG. 15 is a three-dimensional schematic diagram of a floating door panel in an unfolded state according to an embodiment of this application. The first rotating member 8 may be connected to the swing arm 61. In this way, the first rotating member 8 can support the bending part 51 when the foldable electronic device is in the unfolded state. C in FIG. 15 is a schematic diagram obtained after the foldable electronic device in the unfolded state is sectioned along a sectioning line R4 in A in FIG. 15. As shown in C in FIG. 15, in a process in which the foldable electronic device is unfolded, the swing arm 61 drives the first rotating member 8, so that the first rotating member 8 is displaced toward the display screen 5 in the Z-axis direction, and therefore supports the display screen 5 when the foldable electronic device is in an entirely unfolded state. D in FIG. 15 is a schematic diagram obtained after the foldable electronic device in the folded state is sectioned along the sectioning line R4 in A in FIG. 15. When the foldable electronic device is in the folded state, the swing arm 11 drives the first rotating member 8, so that the first rotating member 8 is displaced away from the display screen 5, thereby avoiding the display screen 5.

In this way, when the foldable electronic device is in the unfolded state, the first rotating member 8 can play an auxiliary supporting function for the display screen 5, to compensate for impact caused by disposing the recessed part 411 on the first surface 41 to the strength of the support for the display screen 5.

In the first type of structure of the foldable assembly shown in this application, the recessed part 411 may be disposed on the first surface 41 in correspondence with the projection region of the end part on the at least one side of the bending part 51 on the first surface 41, so that the first gap S1 between the bending part 51 and the recessed part 411 is greater than the second gap S2 between the bending part 51 and the support part in the thickness direction of the substrate 4. In this way, the display screen 5 is avoided by using the first gap S1 when shaft-side corner falling occurs on the foldable electronic device, so that collision stress between the display screen 5 and the foldable assembly when shaft-side corner falling occurs on the foldable electronic device is reduced without affecting overall strength of the foldable assembly. Therefore, damage to the display screen 5 is avoided, and reliability of the foldable electronic device is improved.

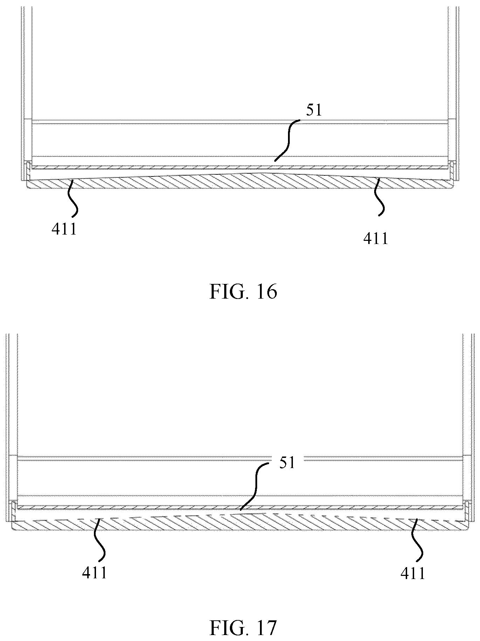

FIG. 16 is a schematic diagram of a second type of structure of the foldable assembly on a cross-section H2 according to an embodiment of this application.

As shown in FIG. 16, in some embodiments, the recessed part 411 may be disposed as an inclined curved surface, and the inclined curved surface may be a continuous curved surface. It should be noted that another component of the foldable assembly may be disposed with reference to the foregoing embodiments. Details are not described in this application.

The first rotating member 8 shown in the first type of structure of the foldable assembly may be applied to another structure in this embodiment of this application, and is adaptively changed based on various structures to play a corresponding supporting function. This is not limited in this application.

FIG. 17 is a schematic diagram of a third type of structure of the foldable assembly according to an embodiment of this application.

FIG. 17 is a cross-sectional view of C in FIG. 7 in a same cross-section. As shown in FIG. 17, in some embodiments, the recessed part 411 may be disposed as an inclined curved surface, and the inclined curved surface may be a discontinuous curved surface.

It should be noted herein that another component of the foldable assembly may be disposed with reference to the foregoing embodiments. Details are not described in this application.

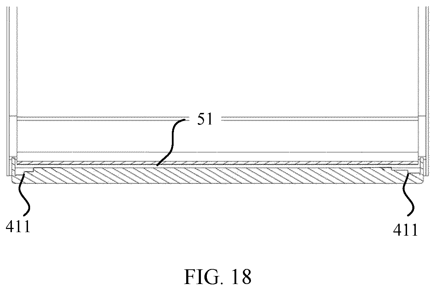

FIG. 18 is a schematic diagram of a fourth type of structure of the foldable assembly according to an embodiment of this application. As shown in FIG. 18, in some embodiments, the recessed part 411 may be set to a stepped shape.

In some embodiments, the foldable assembly may be an axisymmetric assembly, or may be set to an asymmetric assembly.

For example, a camera is disposed on one side of the foldable electronic device. Therefore, when shaft-side corner falling occurs on the foldable electronic device, a falling angle of a shaft-side corner on the side on which the camera is disposed may be deviated from a falling angle of a shaft-side corner on a side on which no camera is disposed. Based on this, an axial length, a radial length, a curvature, and the like of the recessed part 411 may be set to different values, to generate more structures of the foldable assembly.

This embodiment of this application further includes one of the foregoing foldable assembly structures or a combination of a plurality of foldable assembly structures. Details are not described in this embodiment of this application.

In this embodiment of this application, when the first gap S1 is greater than the second gap S2, a plurality of forms, such as the groove, the inclined surface, and the stepped shape, may be selected for the recessed part 411, and the axial length and the radial length of the recessed part 411 are adaptively designed to generate a plurality of structures of the foldable assembly, to reduce collision stress between the display screen 5 and the foldable assembly during shaft-side corner falling of the foldable electronic device. Therefore, damage to the display screen 5 is avoided, and reliability of the foldable electronic device is improved. An embodiment of this application further provides a foldable electronic device. The foldable electronic device includes the foldable assembly provided in the foregoing embodiments, and the foldable electronic device includes but is not limited to a mobile phone, a display, a tablet computer, an in-vehicle computer, and the like. A specific form of the foldable electronic device is not specially limited in embodiments of this application.

According to the foldable electronic device shown in this application, a recessed part 411 may be disposed in a corresponding projection region of two ends of the bending part 51 on a first surface 41, so that a first gap S1 is greater than a second gap S2. In this way, a display screen 5 can be avoided by using the first gap S1 when shaft-side corner falling occurs on the foldable electronic device, so that collision stress between the display screen 5 and a foldable assembly when shaft-side corner falling occurs on the foldable electronic device is reduced without affecting overall strength of the foldable assembly. Therefore, damage to the display screen 5 is avoided, and reliability of the foldable electronic device is improved.

It should be understood that in various embodiments in the embodiments of this application, sequence numbers of the processes do not mean an execution sequence. The execution sequence of the processes should be determined based on functions and internal logic of the processes, and should not be construed as any limitation on the implementation processes of the embodiments.

The parts of this specification are all described in a progressive manner, and for same or similar parts in the embodiments, reference may be made to each other. Descriptions of each embodiment focus on a difference from other embodiments. Especially, for the apparatus and system embodiments, the apparatus and system embodiments are basically similar to the method embodiment, and therefore are described briefly. For related parts, refer to the partial description of the method embodiment.

The objectives, technical solutions, and beneficial effects of this application are further described in detail in the foregoing specific implementations. It should be understood that the foregoing descriptions are merely specific implementations of this application, but are not intended to limit the protection scope of this application.

## Claims

1. A foldable electronic device, comprising a display screen (104), a first body (101), a second body (103), and a rotating shaft (3), wherein
the display screen comprises a bendable part (51), the bendable part comprises an end part and an end surface, and the end part of the bendable part is a part that extends from the end surface of the bendable part by a first distance (D1) in a first direction;
the rotating shaft comprises a substrate (4), and the substrate is disposed between the first body (1) and the second body (2);
**characterized in that**:
the substrate comprises a first surface (41) and an end surface (401), the first surface is a side surface of the substrate facing the bendable part, the first surface comprises a support part (412) and a recessed part (411), and the recessed part is corresponding to the end part of the bendable part;
the recessed part comprises a first end (402) facing the end surface of the substrate (401), and there is a second distance (D2) between the first end and the end surface of the substrate; and
in a second direction, there is a first gap (S1) between the bendable part and the recessed part, there is a second gap (S2) between the bendable part and the support part, and the first gap is greater than the second gap, wherein the first direction is an axial direction (Y-axis) of the substrate, and the second direction is a thickness direction (Z-axis) of the substrate.

2. The foldable electronic device according to claim 1, wherein the recessed part further comprises a second end facing away from the end surface of the substrate; and
there is a third distance between the second end and the end surface of the substrate, and the third distance is greater than the second distance.

3. The foldable electronic device according to claim 1, wherein a component for protecting the substrate and/or the display screen is disposed on the end surface of the substrate.

4. The foldable electronic device according to claim 3, wherein the component comprises a cover body.

5. The foldable electronic device according to any one of claims 1~4, wherein the substrate comprises a shaft cover, a cover plate, and a base.

6. The foldable electronic device according to claim 5, wherein the shaft cover is corresponding to the bendable part; the cover plate is located between the shaft cover and the bendable part, and the cover plate is fixedly connected to the shaft cover to form a cavity; and at least a portion of the base is located inside the cavity.

7. The foldable electronic device according to any one of claims 1~6, wherein the recessed part comprises a recess or an inclined surface.

8. The foldable electronic device according to claim 7, wherein the inclined surface comprises an inclined plane or an inclined curved surface.

9. The foldable electronic device according to any one of claims 1~8, wherein when the foldable electronic device is in a folded state, the first gap is a first value, the second gap is a second value, and the first value is greater than the second value; and
when the foldable electronic device is in an unfolded state, the first gap is a third value, the second gap is a fourth value, and the third value is greater than the fourth value, wherein the first value is different from the third value, and the second value is different from the fourth value.

10. The foldable electronic device according to claim 1, wherein the second gap is greater than or equal to 0.25 millimeter when the foldable electronic device is in a folded state.

11. The foldable electronic device according to claim 10, wherein a difference between the first gap and the second gap is in a range of [0.1, 0.3] millimeter when the foldable electronic device is in the folded state.

12. The foldable electronic device according to claim 11, wherein the second gap is less than or equal to 0.4 millimeter when the foldable electronic device is in the folded state.

## Patentansprüche

1. Faltbare elektronische Vorrichtung, umfassend einen Anzeigebildschirm (104), einen ersten Körper (101), einen zweiten Körper (103) und eine Drehwelle (3), wobei
der Anzeigebildschirm einen biegsamen Teil (51) umfasst, der biegsame Teil einen Endabschnitt und eine Endfläche umfasst und der Endabschnitt des biegsamen Teils ein Teil ist, der sich von der Endfläche des biegsamen Teils um einen ersten Abstand (D1) in einer ersten Richtung erstreckt;
die Drehwelle ein Substrat (4) umfasst und das Substrat zwischen dem ersten Körper (1) und dem zweiten Körper (2) angeordnet ist;
**dadurch gekennzeichnet, dass**:
das Substrat eine erste Fläche (41) und eine Endfläche (401) umfasst, wobei die erste Fläche eine dem biegsamen Teil zugewandte Seitenfläche des Substrats ist, die erste Fläche einen Stützabschnitt (412) und einen ausgenommenen Teil (411) umfasst und der ausgenommene Teil dem Endabschnitt des biegsamen Teils entspricht;
der ausgenommene Teil ein der Endfläche des Substrats (401) zugewandtes erstes Ende (402) umfasst und ein zweiter Abstand (D2) zwischen dem ersten Ende und der Endfläche des Substrats besteht; und
in einer zweiten Richtung ein erster Spalt (S1) zwischen dem biegsamen Teil und dem ausgenommenen Teil besteht, ein zweiter Spalt (S2) zwischen dem biegsamen Teil und dem Stützabschnitt besteht und der erste Spalt größer als der zweite Spalt ist, wobei
die erste Richtung eine axiale Richtung (Y-Achse) des Substrats ist und die zweite Richtung eine Dickenrichtung (Z-Achse) des Substrats ist.

2. Faltbare elektronische Vorrichtung nach Anspruch 1, wobei der ausgenommene Teil ferner ein von der Endfläche des Substrats abgewandtes zweites Ende umfasst; und
ein dritter Abstand zwischen dem zweiten Ende und der Endfläche des Substrats besteht und der dritte Abstand größer als der zweite Abstand ist.

3. Faltbare elektronische Vorrichtung nach Anspruch 1, wobei eine Komponente zum Schützen des Substrats und/oder des Anzeigebildschirms auf der Endfläche des Substrats angeordnet ist.

4. Faltbare elektronische Vorrichtung nach Anspruch 3, wobei die Komponente einen Abdeckkörper umfasst.

5. Faltbare elektronische Vorrichtung nach einem der Ansprüche 1 bis 4, wobei das Substrat eine Wellenabdeckung, eine Abdeckplatte und eine Basis umfasst.

6. Faltbare elektronische Vorrichtung nach Anspruch 5, wobei die Wellenabdeckung dem biegsamen Teil entspricht; die Abdeckplatte zwischen der Wellenabdeckung und dem biegsamen Teil angeordnet ist und die Abdeckplatte fest mit der Wellenabdeckung verbunden ist, um einen Hohlraum zu bilden; und mindestens ein Abschnitt der Basis innerhalb des Hohlraums angeordnet ist.

7. Faltbare elektronische Vorrichtung nach einem der Ansprüche 1 bis 6, wobei der ausgenommene Teil eine Aussparung oder eine geneigte Fläche umfasst.

8. Faltbare elektronische Vorrichtung nach Anspruch 7, wobei die geneigte Fläche eine geneigte Ebene oder eine geneigte gekrümmte Fläche umfasst.

9. Faltbare elektronische Vorrichtung nach einem der Ansprüche 1 bis 8, wobei, wenn sich die faltbare elektronische Vorrichtung in einem gefalteten Zustand befindet, der erste Spalt ein erster Wert ist, der zweite Spalt ein zweiter Wert ist und der erste Wert größer als der zweite Wert ist; und
wenn sich die faltbare elektronische Vorrichtung in einem entfalteten Zustand befindet, der erste Spalt ein dritter Wert ist, der zweite Spalt ein vierter Wert ist und der dritte Wert größer als der vierte Wert ist, wobei der erste Wert von dem dritten Wert verschieden ist und der zweite Wert von dem vierten Wert verschieden ist.

10. Faltbare elektronische Vorrichtung nach Anspruch 1, wobei der zweite Spalt größer oder gleich 0,25 Millimeter ist, wenn sich die faltbare elektronische Vorrichtung in einem gefalteten Zustand befindet.

11. Faltbare elektronische Vorrichtung nach Anspruch 10, wobei eine Differenz zwischen dem ersten Spalt und dem zweiten Spalt in einem Bereich von [0,1; 0,3] Millimeter liegt, wenn sich die faltbare elektronische Vorrichtung im gefalteten Zustand befindet.

12. Faltbare elektronische Vorrichtung nach Anspruch 11, wobei der zweite Spalt kleiner oder gleich 0,4 Millimeter ist, wenn sich die faltbare elektronische Vorrichtung im gefalteten Zustand befindet.

## Revendications

1. Dispositif électronique pliable, comprenant un écran d'affichage (104), un premier corps (101), un second corps (103) et un arbre rotatif (3), dans lequel
l'écran d'affichage comprend une partie pliable (51), la partie pliable comprend une partie d'extrémité et une surface d'extrémité, et la partie d'extrémité de la partie pliable est une partie qui s'étend depuis la surface d'extrémité de la partie pliable d'une première distance (D1) dans une première direction ;
l'arbre rotatif comprend un substrat (4), et le substrat est disposé entre le premier corps (1) et le second corps (2) ;
**caractérisé en ce que** :
le substrat comprend une première surface (41) et une surface d'extrémité (401), la première surface est une surface latérale du substrat faisant face à la partie pliable, la première surface comprend une partie de support (412) et une partie en retrait (411), et la partie en retrait correspond à la partie d'extrémité de la partie pliable ;
la partie en retrait comprend une première extrémité (402) faisant face à la surface d'extrémité du substrat (401), et il existe une deuxième distance (D2) entre la première extrémité et la surface d'extrémité du substrat ; et
dans une seconde direction, il existe un premier intervalle (S1) entre la partie pliable et la partie en retrait, il existe un deuxième intervalle (S2) entre la partie pliable et la partie de support, et le premier intervalle est supérieur au deuxième intervalle, dans lequel
la première direction est une direction axiale (axe Y) du substrat, et la seconde direction est une direction d'épaisseur (axe Z) du substrat.

2. Dispositif électronique pliable selon la revendication 1, dans lequel la partie en retrait comprend en outre une seconde extrémité orientée à l'opposé de la surface d'extrémité du substrat ; et
il existe une troisième distance entre la seconde extrémité et la surface d'extrémité du substrat, et la troisième distance est supérieure à la deuxième distance.

3. Dispositif électronique pliable selon la revendication 1, dans lequel un composant pour protéger le substrat et/ou l'écran d'affichage est disposé sur la surface d'extrémité du substrat.

4. Dispositif électronique pliable selon la revendication 3, dans lequel le composant comprend un corps de couvercle.

5. Dispositif électronique pliable selon l'une quelconque des revendications 1 à 4, dans lequel le substrat comprend un couvercle d'arbre, une plaque de recouvrement et une base.

6. Dispositif électronique pliable selon la revendication 5, dans lequel le couvercle d'arbre correspond à la partie pliable ; la plaque de recouvrement est située entre le couvercle d'arbre et la partie pliable, et la plaque de recouvrement est reliée de manière fixe au couvercle d'arbre pour former une cavité ; et au moins une portion de la base est située à l'intérieur de la cavité.

7. Dispositif électronique pliable selon l'une quelconque des revendications 1 à 6, dans lequel la partie en retrait comprend un évidement ou une surface inclinée.

8. Dispositif électronique pliable selon la revendication 7, dans lequel la surface inclinée comprend un plan incliné ou une surface courbe inclinée.

9. Dispositif électronique pliable selon l'une quelconque des revendications 1 à 8, dans lequel, lorsque le dispositif électronique pliable est dans un état plié, le premier intervalle est une première valeur, le deuxième intervalle est une deuxième valeur, et la première valeur est supérieure à la deuxième valeur ; et
lorsque le dispositif électronique pliable est dans un état déplié, le premier intervalle est une troisième valeur, le deuxième intervalle est une quatrième valeur, et la troisième valeur est supérieure à la quatrième valeur, dans lequel la première valeur est différente de la troisième valeur, et la deuxième valeur est différente de la quatrième valeur.

10. Dispositif électronique pliable selon la revendication 1, dans lequel le deuxième intervalle est supérieur ou égal à 0,25 millimètre lorsque le dispositif électronique pliable est dans un état plié.

11. Dispositif électronique pliable selon la revendication 10, dans lequel une différence entre le premier intervalle et le deuxième intervalle est dans une plage de [0,1 ; 0,3] millimètre lorsque le dispositif électronique pliable est dans l'état plié.

12. Dispositif électronique pliable selon la revendication 11, dans lequel le deuxième intervalle est inférieur ou égal à 0,4 millimètre lorsque le dispositif électronique pliable est dans l'état plié.
